# EUROPÄISCHE PATENTSCHRIFT

(11) **EP 1 497 859 B1**
(45) Veröffentlichungstag und Bekanntmachung des Hinweises auf die Patenterteilung: **15.09.2010**
(21) Anmeldenummer: 03722271.8
(22) Anmeldetag: 10.04.2003
(51) Int. Cl.: H01L 21/768

(54) **VERFAHREN ZUR HERSTELLUNG DÜNNER METALLHALTIGER SCHICHTEN MIT GERINGEM ELEKTRISCHEN WIDERSTAND**
METHOD FOR THE PRODUCTION OF THIN METAL-CONTAINING LAYERS HAVING LOW ELECTRICAL RESISTANCE
PROCEDE DE PRODUCTION DE COUCHES MINCES CONTENANT DU METAL PRESENTANT UNE FAIBLE RESISTANCE ELECTRIQUE

(30) Priorität: 22.04.2002 DE 10217876
(43) Veröffentlichungstag der Anmeldung: 19.01.2005
(73) Patentinhaber: Infineon Technologies AG, 85579 Neubiberg (DE)
(72) Erfinder: BARTH, Hans-Joachim, 81245 München (DE); TEWS, Helmut, 81549 München (DE)
(74) Vertreter: Karl, Frank
(86) Internationale Anmeldenummer: PCT/DE2003/001205
(87) Internationale Veröffentlichungsnummer: WO 2003/090257

(56) Entgegenhaltungen:
- US-A- 3 585 088
- US-A- 5 405 804
- US-B1- 6 242 808

## Beschreibung

Die vorliegende Erfindung bezieht sich auf ein Verfahren zur Herstellung strukturierter Leiterbahnen mit geringem elektrischen Widerstand und insbesondere auf dünne Cu-Leiterbahnen zur Verwendung in Halbleiterbauelementen.

Bisher wurden bei der Herstellung von integrierten Halbleiterschaltungen vorzugsweise Aluminiumschichten in jeweiligen Verdrahtungsebenen zur Realisierung von Leiterbahnen abgeschieden und strukturiert, wobei grundsätzlich eine Al-Schicht bis zu einer vorbestimmten Dicke abgeschieden und anschließend mittels herkömmlicher fotolithographischer und dazugehöriger Ätzverfahren strukturiert wurde.

Zunehmend werden jedoch alternative Materialien insbesondere zur Verwendung in derartigen Metallisierungsschichten eingesetzt, um der zunehmenden Integrationsdichte gerecht zu werden. Durch die Verwendung von beispielsweise Kupfer für derartige Verdrahtungsebenen konnten auf Grund der gegenüber Aluminium wesentlich geringeren Widerstände integrierte Schaltungen entwickelt werden, die bei wesentlich höheren Geschwindigkeiten und bei einem geringeren Leistungsverbrauch arbeiten. Nachteilig ist jedoch bei der Verwendung von derartigen alternativen Materialien, insbesondere bei Verwendung von Kupfer, die relativ schwere Handhabbarkeit, die sich beispielsweise aus Abscheide- und/oder Ätzproblemen ergibt.

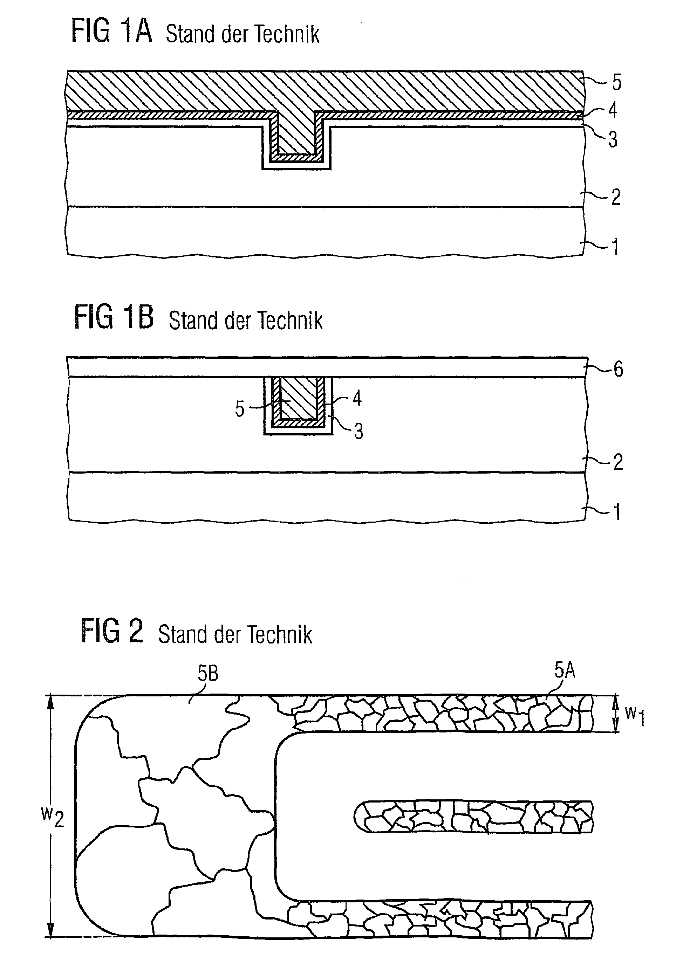

Zur Beseitigung derartiger Probleme wurde beispielsweise die in der Figuren 1a und 1b dargestellte Damascene-Technologie entwickelt.

Die Figuren 1a und 1b zeigen vereinfachte Schnittdarstellungen zur Veranschaulichung wesentlicher Herstellungsschritte eines derartigen herkömmlichen Damascene-Verfahrens zur Ausbildung dünner metallhaltiger Schichten.

Gemäß Figur 1a befindet sich auf einem Trägersubstrat 1, welches beispielsweise eine integrierte Halbleiterschaltung in einem Halbleitersubstrat mit darüber liegenden Elementschichten darstellt, eine dielektrische Schicht 2, in der ein Graben für eine später auszubildende Leiterbahn ausgebildet wird. In nachfolgenden Schritten wird sowohl an der Oberfläche als auch im Graben der dielektrischen Schicht 2 eine Diffusionsbarrierenschicht 3 (liner) und eine Keimschicht 4 (seed layer) ausgebildet, die ein nachfolgendes Aufwachsen einer Cu-Schicht 5 ermöglicht bzw. vereinfacht.

Gemäß Figur 1b wird nachfolgend beispielsweise mittels eines CMP-Verfahrens (Chemical Mechanical Polishing) die oberhalb des Grabens verbleibende Schichtenfolge entfernt und eine weitere Diffusionsbarrierenschicht 6 als sogenannte Caplayer ausgebildet.

Auf diese Weise können auch sehr fein strukturierte Leiterbahnen mit schwierig handhabbaren Materialien hergestellt werden. Nachteilig ist hierbei jedoch insbesondere bei Strukturgrößen kleiner 0,2 Mikrometern eine wesentliche Verschlechterung der elektrischen Leitfähigkeit auf Grund von Korngrößenproblemen innerhalb der metallhaltigen Schicht 5.

Figur 2 zeigt eine vereinfachte Draufsicht einer unterschiedlich strukturierten Leiterbahn gemäß einem weiteren Stand der Technik, wie er beispielsweise aus der Literaturstelle Q. T. Jiang et al., Proceedings of 2001 IICT Conference, Seiten 227 bis 229 bekannt ist. Gemäß dieser Druckschrift wurde die in Figur 2 dargestellte strukturabhängige Rekristallisation übergangsweise festgestellt, wobei in fein strukturierten Bereichen mit beispielsweise einer Strukturbereite w1 im Gegensatz zu grob strukturierten Bereichen mit einer Strukturbreite w2 eine metallhaltige Schicht mit unterschiedlichen Korngrößen 5A und 5B ausgebildet werden. Hierbei weisen die fein strukturierten Bereiche mit einer Breite w1 auf Grund ihrer geringeren Korngröße einen wesentlich größeren Widerstand auf als die grob strukturierten Bereiche 5B mit ihren großen Korngrößen. Nachteilig ist hierbei jedoch, dass in den fein strukturierten Bereichen sich auch bei höherer Ausheiltemperatur und bei verlängerter Ausheilzeit nicht die selben großen Korngrößen erzeugen lassen wie in den grob strukturierten Bereichen, da die maximale Korngröße im Wesentlichen durch die Geometrie der zu füllenden Strukturen begrenzt ist.

Aus der Druckschrift US-B-6 242 808 ist ein Verfahren zur Herstellung einer Damascene-Verdrahtung bekannt, wobei das Trägermaterial eine Diffusionsbarrierenschicht sowie eine Keimschicht aufweist. Ein thermischer Ausheilvorgang zur Realisierung einer Kristallisation findet hierbei in einer Schutzgasatmosphäre bei 400°C statt.

Aus der Druckschrift US-A-5 405 804 ist ein Verfahren zur Herstellung strukturierter Leiterbahnen mit geringem elektrischen Widerstand bekannt, wobei strukturierte metallhaltige Leiterbahnen mit einer ersten Korngröße auf einem Trägermaterial ausgebildet werden und ein lokal begrenzter Wärmebereich erzeugt wird. Auf diese Weise wird bei der Rekristallisation der Leiterbahnen eine vergrößerte zweite Korngröße erzeugt, wodurch die elektrischen Eigenschaften der Leiterbahnen grundsätzlich verbessert werden.

Demgegenüber liegt der Erfindung die Aufgabe zugrunde, ein Verfahren zur Herstellung strukturierter Leiterbahnen zu schaffen, wobei die elektrischen Eigenschaften der Leiterbahnen weiter verbessert sind.

Erfindungsgemäß wird diese Aufgabe durch die Maßnahmen des Patentanspruchs 1 gelöst.

Durch das Einstellen einer Bewegung des Wärmebereichs in Richtung der strukturierten metallhaltigen Leiterbahnen derart, dass eine Rekristallisation der Leiterbahn zum Erzeugen einer Leiterbahn mit einer zur ersten Korngröße verlängerten zweiten Korngröße durchgeführt wird, erhält man für Leiterbahnen die eine Breite kleiner 0,2 µm haben eine weitere Erhöhung der Leitfähigkeit und Verbesserung der Elektromigrationseigenschaften.

Vorzugsweise werden Leiterbahnen in einer Primärrichtung und/oder in einer zur Primärrichtung im Wesentlichen senkrechten Sekundärrichtung ausgebildet.

Auf diese Weise können die in einer Halbleiterschaltung üblicherweise orthogonal zueinander angeordneten Leiterbahnen in ihren jeweiligen Ausbreitungsrichtungen rekristallisiert werden, wodurch sich vergrößerte Korngrößen und somit verringerte Leitungswiderstände und verbesserte Elektromigrationseigenschaften ergeben. Bei einer in einem Winkel von 45 Grad durchgeführten Bewegung des Wärmebereichs über die metallhaltige Ausgangsschicht kann eine Rekristallisation besonders einfach, schnell und somit kostengünstig für einen gesamten Halbleiterbaustein oder Halbleiterwafer realisiert werden. Ein derartiges Überstreichen des Wärmebereichs über die zu rekristallisierende metallhaltige Schicht kann hierbei auch mehrfach durchgeführt werden, wodurch man verbesserte Rekristallisationsergebnisse und damit verbesserte elektrische Eigenschaften sowie Elektromigrationseigenschaften erhält.

Vorzugsweise wird der lokal begrenzte Wärmebereich durch einen aufgefächerten Laserstrahl, ein heißes Gas, eine Vielzahl von Heizlampen und/oder einen Heizdraht erzeugt, die mit einer vorbestimmten Geschwindigkeit über die metallhaltige Ausgangsschicht geführt werden. Bei einer derartigen Erzeugung des Wärmebereichs, die beispielsweise auch in einer Schutzgasatmosphäre stattfinden kann, kann eine Rekristallisation der metallhaltigen Ausgangsschicht besonders effektiv und schnell durchgeführt werden. Der lokal begrenzte Wärmebereich kann hierbei beispielsweise streifenförmig oder punktförmig ausgebildet sein.

Die metallhaltige Ausgangsschicht kann eine Metalllegierung oder ein dotiertes Metall mit einem Fremdanteil kleiner 5% aufweisen, wobei während der Wärmebehandlung die Fremdanteile bzw. Dotierstoffe an die Oberfläche ausdiffundieren und eine selbstpassivierende Oberflächenschicht erzeugen können. Auf diese Weise können bei der Herstellung von Leiterbahnen mittels der Damascene-Technologie zusätzliche Passivierungsschritte entfallen.

Insbesondere bei der Verwendung des Verfahrens zur Ausbildung von Halbleiterschaltungen liegt eine Temperatur des lokal begrenzten Wärmebereichs in einem Bereich von 150 Grad Celsius bis 450 Grad Celsius, wodurch die elektrischen Eigenschaften insbesondere von sogenannten Low k-Dielektrika nicht negativ beeinflusst werden. Ferner kann durch die Verwendung von Diffusionsbarrierenschichten und Keimschichten ein verbesserter Kristallisationsvorgang der metallhaltigen Ausgangsschicht herbeigeführt und eine unerwünschte Diffusion von die elektrischen Eigenschaften der Halbleiterschaltung verschlechternden Stoffen zuverlässig verhindert werden.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahem auf die Zeichnung näher beschrieben.

Es zeigen:
Figuren 1a und 1b vereinfachte Schnittansichten zur Veranschaulichung wesentlicher Herstellungsschritte in einem herkömmlichen Damascene-Verfahren;
Figur 2 eine vereinfachte Draufsicht zur Veranschaulichung von strukturbedingten Rekristallisationseigenschaften gemäß dem Stand der Technik;
Figur 3 eine vereinfachte Draufsicht zur Veranschaulichung eines Herstellungsverfahrens gemäß einem Ausführungsbeispiel; und
Figur 4 eine vereinfachte Draufsicht zur Veranschaulichung eines Herstellungsverfahrens gemäß einem Beispiel.

Die Erfindung wird nachstehend anhand einer Cu-Schicht als metallhaltige Schicht beschrieben, wobei in gleicher Weise auch andere metallhaltige Schichten und insbesondere Al, Ag, Pt und/oder Au verwendet werden können. Derartige alternative Materialien zur Realisierung von Metallisierungsschichten gewinnen insbesondere in der Halbleitertechnik zunehmend an Bedeutung, da sie eine verbesserte Leitfähigkeit und somit erhöhte Taktraten sowie einen verringerten Leistungsverbrauch ermöglichen.

Insbesondere bei sehr kleinen Strukturgrößen von kleiner 0,1 Mikrometer (hinsichtlich ihrer Dicke oder Höhe) ergeben sich jedoch die eingangs beschriebenen Probleme, wobei insbesondere auf Grund der sehr kleinen Korngrößen im elektrisch leitenden Material eine wesentliche Widerstandserhöhung einsetzt. Ferner führen derartige kleine Korngrößen zu einer verstärkten, jedoch unerwünschten Elektromigration in Richtung der jeweiligen Leiterbahnen. Auf diese Weise können die Vorteile derartiger neuer bzw. alternativer Verdrahtungsmaterialien verringert werden.

Das erfindungsgemäße Verfahren zeigt nunmehr, wie auf einfache Art und Weise für sehr kleine Leiterbahnbreiten kleiner 0,2 Mikrometer dünne metallhaltige Leiterbahnen mit geringem elektrischen Widerstand und verbesserten Elektromigrationseigenschaften hergestellt werden können.

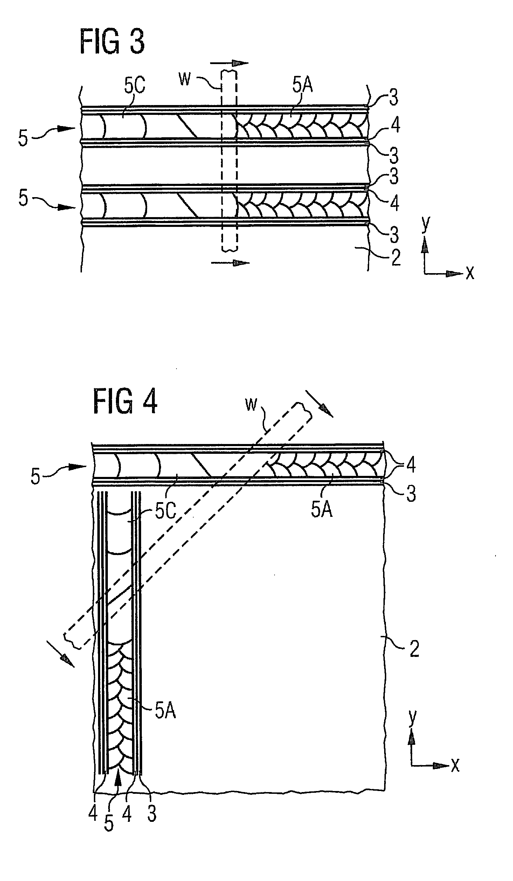

Figur 3 zeigt eine vereinfachte Draufsicht strukturierter metallhaltiger Leiterbahnen 5 zur Veranschaulichung eines wesentlichen Verfahrensschrittes bei der Herstellung gemäß einem ersten Ausführungsbeispiel.

Die strukturierten metallhaltigen Leiterbahnen 5 wurden mit der in den Figuren 1a und 1b dargestellten Damascene-Technologie hergestellt, wobei gleiche Bezugszeichen gleiche oder entsprechende Elemente bzw. Schichten beschreiben und auf eine wiederholte Beschreibung nachfolgend verzichtet wird. Mit einer derartigen herkömmlichen Damascene-Technologie können demzufolge in einer dielektrischen Schicht 2 bzw. in darin ausgebildeten Gräben eine Diffusionsbarrierenschicht 3, eine Keimschicht 4 und eine metallhaltige Ausgangsschicht 5A, die eine erste Korngröße aufweist, ausgebildet werden, wobei sich nach einem CMP-Verfahren die in Figur 3 dargestellte Draufsicht ergibt.

Nach einer derartigen Realisierung von sehr schmalen (z.B. kleiner 0,1 Mikrometer) Dual-Damascene-Cu-Leiterbahnen 5 streicht beispielsweise ein aufgefächerter Laserstrahl zum Erzeugen eines lokal begrenzten Wärmebereichs W langsam entlang einer Primärrichtung x der Leiterbahnen bzw. metallhaltigen Schichten 5 und erwärmt diese auf eine lokale Temperatur innerhalb eines Bereichs von ca. 150 Grad Celsius bis 450 Grad Celsius. Die Bewegung (z.B. 1 cm/Sekunde) der so erzeugten Temperaturfront entlang der Leiterbahn 5 ermöglicht eine Rekristallisation der kleinen und zufällig verteilten Kupferkörner von einer ersten Korngröße 5A zu einer vergrößerten zweiten Korngröße 5C. Genauer gesagt ergibt sich hierbei eine Tendenz zum Erzeugen von in Bewegungsrichtung bzw. in Richtung der Leiterbahnen 5 verlängerten Körnern.

Auf Grund der Verlängerung der Cu-Körner entlang der Leiterbahnen 5 ergibt sich für den elektrischen Strom bzw. die entsprechenden freien Ladungsträger ein signifikant verringertes Korngrößenscattering (Grain Boundary Scattering). Gleichzeitig bewirkt dies einen signifikant verringerten Widerstand, was wiederum zu einer höheren Leitfähigkeit und verbesserten Elektromigrationseigenschaften führt. Insbesondere in Halbleiterschaltungen können auf diese Weise der Leistungsverbrauch verringert und die Taktraten erhöht werden.

Während der Laserabtastung bzw. während des Überstreichens des lokal begrenzten Wärmebereichs W über die metallhaltige Ausgangsschicht 5A mit ihrer ersten Korngröße sollte die Temperatur nicht über 450 Grad Celsius hinaus gehen, da eine Vielzahl von sogenannten Low k-Dielektrika, die beispielsweise die Cu-Leiterbahnen 5 umgeben, derartigen Temperaturen nicht Stand halten und darüber hinaus niedrigere Temperaturen die Wahrscheinlichkeit für sogenannte Cu-Hillock-Ausbildung verringern. Ferner kann bei einem derartigen Temperaturbereich ein unerwünschtes Ausdiffundieren von Dotierstoffen im Halbleitermaterial und damit eine Verschlechterung der elektrischen Eigenschaften von Halbleiterelementen zuverlässig verhindert werden.

Vorzugsweise wird dieser Vorgang in einer Schutzgasatmosphäre aus N₂, Ar, He oder in einem Vakuum durchgeführt, wodurch beispielsweise eine Oxidation der metallhaltigen Schicht verringert bzw. verhindert wird.

Die im vorliegenden Ausführungsbeispiel verwendete Keimschicht 4 besteht beispielsweise aus einer Cu-Keimschicht, wodurch die metallhaltige Cu-Anfangsschicht 5A besonders effektiv und einfach ausgebildet werden kann. Verfahren zum Ausbilden dieser metallhaltigen Anfangsschicht 5A sind beispielsweise herkömmliche PVD- oder CVD-Verfahren, wobei jedoch vorzugsweise ein galvanisches bzw. elektrochemisches Abscheideverfahren (ECD, Electro Chemical Deposition) verwendet werden kann. Hierbei wird die Keimschicht 4 als Aufwachselektrode für die metallhaltige Anfangsschicht 5A mit ihrer ersten Korngröße verwendet.

Alternativ zu dem vorstehend beschriebenen Kupfer oder den weiteren Materialien, wie beispielsweise Al, Ag, Pt oder Au, können für die metallhaltige Anfangsschicht 5A auch Legierungen oder sogenannte dotierte Metalle als metallhaltige Anfangsschicht 5A verwendet werden, wodurch sich je nach Bedarf verbesserte elektrischen Eigenschaften oder eine vereinfachte Herstellung ergibt. Derartige dotierte Metalle sind beispielsweise AlCu mit 0,5% Cu, AlSiCu mit 1% Si und 0,5% Cu, CuTi, CuIn, CuSn, CuMg, CuAl, CuZr, usw. wobei die Dotierstoffkonzentration im Wesentlichen kleiner 5% ist.

Insbesondere bei der Verwendung von derartigen Metalllegierungen oder dotierten Metallen mit einem Fremdanteil kleiner 5% können spätere Passivierungsschritte eingespart werden, wodurch sich eine Vereinfachung und Kostenersparnis ergibt. Genauer gesagt werden bei Verwendung derartiger Metalllegierungen oder dotierter Metalle für die metallhaltige Anfangsschicht 5A während der Wärmebehandlung durch den lokal begrenzten Wärmebereich W Dotierstoffe bzw. Fremdanteile an die Oberfläche ausdiffundiert, wodurch eine Selbstpassivierungs-Oberflächenschicht erzeugt wird. In diesem Fall kann eine Abscheidung der beispielsweise in Figur 1b dargestellten Cap-Schicht 6 entfallen, die üblicherweise aus SiN, SiC, BlOK usw. besteht.

Alternativ zu der vorstehend beschriebenen Laser-Wärmequelle zum Erzeugen eines aufgefächerten Laserstrahls kann der lokal begrenzte Wärmebereich W auch durch ein heißes Gas wie z.B. Ar, N₂ oder He, welches durch eine entsprechend geformte Düse ausströmt, einen Heizdraht oder eine Vielzahl von in einem Array angeordneten Heizlampen erzeugt werden. Je nach gefahrenem Standardprozess kann somit die einfachste und kostengünstigste Lösung realisiert werden.

Die in Pfeilrichtung durchgeführte Bewegung des lokal begrenzten Wärmebereichs W wird hierbei in Abhängigkeit von der zugeführten Energiemenge derart eingestellt, dass sich jeweils eine optimale Rekristallisation der metallhaltigen Anfangsschicht 5A mit der ersten Korngröße zur metallhaltigen Schicht 5C mit seiner zur ersten Korngröße verlängerten zweiten Korngröße ergibt.

Figur 4 zeigt eine vereinfachte Draufsicht einer strukturierten metallhaltigen Schicht 5 zur Veranschaulichung eines Herstellungsverfahrens, wobei gleiche Bezugszeichen gleiche oder entsprechende Elemente bzw. Schichten wie in den Figuren 1 und 3 bezeichnen und auf eine wiederholte Beschreibung nachfolgend verzichtet wird.

Gemäß Figur 4 sind die metallhaltigen Anfangsschichten 5A mit ihrer ersten Korngröße nicht ausschließlich in einer Primärrichtung x, sondern auch in einer zur Primärrichtung x im Wesentlichen senkrechten Sekundärrichtung y ausgebildet, wie sie üblicherweise in Halbleiterschaltungen als Leiterbahnen angeordnet sind.

Gemäß einer nicht dargestellten Ausführungsform kann der lokal begrenzte Wärmebereich W nunmehr zunächst in der Primärrichtung x und anschließend in der Sekundärrichtung y bewegt werden, wodurch sich in den dazugehörigen Leiterbahnbereichen die erfindungsgemäße Rekristallisation zu den verlängerten zweiten Korngrößen in der metallhaltigen Schicht 5C einstellt.

Gemäß Figur 4 kann zur schnelleren und effektiveren Realisierung dieser Rekristallisation jedoch auch ein im Winkel von 45 Grad zur Primär- und Sekundärrichtung x und y durchgeführter Abtastvorgang durchgeführt werden, wobei gleichzeitig die Leiterbahnbereiche in der Primärrichtung x als auch in der Sekundärrichtung y rekristallisiert und in die verlängerten bzw. vergrößerten Kristallgrößen der metallhaltigen Schicht 5C umgewandelt werden. Demzufolge kann die Bewegung des lokal begrenzten Wärmebereichs W nicht nur in der Primärrichtung x oder der Sekundärrichtung y, sondern auch in einer im Winkel (von vorzugsweise 45 Grad) dazu stehenden Richtung bewegt werden, wodurch sich eine besonders wirkungsvolle Rekristallisierung insbesondere von Halbleiterwafern ergibt. Darüber hinaus ist auch ein wiederholtes Überstreichen in den verschiedenen Richtungen möglich, wodurch sich teilweise eine Rekristallisationsqualität verbessern bzw. eine weitergehende Vergrößerung der Korngrößen erreichen lässt.

Somit lassen sich sehr dünne und eng nebeneinander liegende Leiterbahnen mit einer Breite von kleiner 0,2 Mikrometern hinsichtlich ihrer Leitfähigkeit und Elektromigrationseigenschaften wesentlich verbessern.

Die Erfindung wurde vorstehend anhand einer Dual-Damascene-Cu-Schicht als metallhaltige Anfangsschicht beschrieben, sie ist jedoch nicht darauf beschränkt und umfasst in gleicher Weise alternative metallhaltige Materialien.

In gleicher Weise ist die vorliegende Erfindung nicht auf ein Trägersubstrat beschränkt, welches eine Halbleiterschaltung beinhaltet, sondern kann in gleicher Weise auf beliebigen anderen Trägermaterialien ausgebildet werden, auf denen eine sehr dünne elektrisch leitende Schicht mit geringem elektrischen Widerstand ausgebildet werden soll.

Darüber hinaus muss die vorstehend beschriebene Wärmebehandlung auch nicht auf eine freiliegende metallhaltige Anfangsschicht angewendet werden, sondern es können auch eine oder mehrere Schutzschichten oberhalb oder unterhalb der zu rekristallisierenden metallhaltigen Anfangsschicht liegen. Insbesondere können demzufolge vor der Temperaturbehandlung bereits die Cap-Schicht 6 und nicht dargestellte Zwischenmetall-Dielektrika ausgebildet sein.

## Patentansprüche

1. Verfahren zur Herstellung strukturierter Leiterbahnen mit geringem elektrischen Widerstand mit den Schritten
a) Ausbilden von strukturierten metallhaltigen Leiterbahnen (5A) mit einer ersten Korngröße auf einem Trägermaterial (1, 2, 3, 4) mittels eines Damascene-Verfahrens;
b) Erzeugen eines lokal begrenzten Wärmebereichs (W); und
c) Einstellen einer Bewegung des Wärmebereichs (W) in Richtung der strukturierten metallhaltigen Leiterbahnen (5A) derart, dass eine Rekristallisation der Leiterbahnen (5A) zum Erzeugen von Leiterbahnen (5C) mit einer zur ersten Korngröße verlängerten zweiten Korngröße durchgeführt wird, wobei
die strukturierten Leiterbahnen (5, 5A, 5C) eine Breitekleiner 0,2 µm haben.

2. Verfahren nach Patentanspruch 1,
**dadurch gekennzeichnet, dass** in Schritt a) die Leiterbahnen (5) in einer Primärrichtung (x) und/oder in einer zur Primärrichtung im Wesentlichen senkrechten Sekundärrichtung (y) ausgebildet werden.

3. Verfahren nach einem der Patentansprüche 1 oder 2, **dadurch gekennzeichnet, dass** Schritt b) wiederholt durchgeführt wird.

4. Verfahren nach einem der Patentansprüche 1 bis 3,
**dadurch gekennzeichnet, dass** in Schritt b) der lokal begrenzte Wärmebereich (W) durch einen aufgefächerten Laserstrahl, ein heißes Gas, eine Vielzahl von Heizlampen und/oder einen Heizdraht erzeugt wird.

5. Verfahren nach einem der Patentansprüche 1 bis 4,
**dadurch gekennzeichnet, dass** der lokal begrenzte Wärmebereich (W) streifenförmig oder punktförmig ausgebildet wird.

6. Verfahren nach einem der Patentansprüche 1 bis 5,
**dadurch gekennzeichnet, dass** in Schritt a) die Leiterbahnen (5) eine Metalllegierung oder ein dotiertes Metall mit einem Fremdanteil kleiner 5% aufweisen.

7. Verfahren nach einem der Patentansprüche 1 bis 6,
**dadurch gekennzeichnet, dass** das Trägermaterial eine Diffusionsbarrierenschicht (3) und/oder eine Keimschicht (4) aufweist.

8. Verfahren nach einem der Patentansprüche 1 bis 7,
**dadurch gekennzeichnet, dass** der lokal begrenzte Wärmebereich (W) eine Temperatur von 150 Grad Celsius bis 450 Grad Celsius aufweist.

9. Verfahren nach einem der Patentansprüche 1 bis 8,
**dadurch gekennzeichnet, dass** die Rekristallisation in einer Schutzgasamosphäre durchgeführt wird.

## Claims

1. Method for fabricating patterned interconnects having low electrical resistance, having the following steps
a) formation of patterned metal-containing interconnects (5A) having a first grain size on a carrier material (1, 2, 3, 4) by means of a damascene method;
b) production of a locally delimited thermal region (W); and
c) setting of a movement of the thermal region (W) in the direction of the patterned metal-containing interconnects (5A) in such a way that a recrystallization of the interconnects (5A) is carried out for the purpose of producing interconnects (5C) having a second grain size, which is lengthened with respect to the first grain size,
the patterned interconnects (5, 5A, 5C) having a width of less than 0.2 µm.

2. Method according to Patent Claim 1,
**characterized in that**, in step a), the interconnects (5) are formed in a primary direction (x) and/or in a secondary direction (y), which is essentially perpendicular to the primary direction.

3. Method according to either of Patent Claims 1 and 2,
**characterized in that** step b) is carried out repeatedly.

4. Method according to one of Patent Claims 1 to 3, **characterized in that**, in step b), the locally delimited thermal region (W) is produced by means of a fanned-out laser beam, a hot gas, a multiplicity of heating lamps and/or a heating wire.

5. Method according to one of Patent Claims 1 to 4, **characterized in that** the locally delimited thermal region (W) is formed in strip-type or point-type fashion.

6. Method according to one of Patent Claims 1 to 5, **characterized in that**, in step a), the interconnects (5) comprise a metal alloy or a doped metal with an impurity proportion of less than 5%.

7. Method according to one of Patent Claims 1 to 6, **characterized in that** the carrier material has a diffusion barrier layer (3) and/or a seed layer (4).

8. Method according to one of Patent Claims 1 to 7, **characterized in that** the locally delimited thermal region (W) has a temperature of 150 degrees Celsius to 450 degrees Celsius.

9. Method according to one of Patent Claims 1 to 8, **characterized in that** the recrystallization is carried out in a protective gas atmosphere.

## Revendications

1. Procédé de production de pistes conductrices structurées ayant une résistance électrique petite, comprenant les stades dans lesquels :
a) on forme des pistes (5A) conductrices structurées comprenant du métal ayant une première granulométrie sur un matériau (1, 2, 3, 4) servant de support au moyen d'un procédé damascène ;
b) on produit une zone (W) de chaleur délimitée localement ; et
c) on règle un déplacement de la zone (W) de chaleur en direction des pistes (5A) conductrices structurées contenant du métal, de façon à effectuer une recristallisation des pistes (5A) conductrices pour la production de pistes (5C) conductrices ayant une deuxième granulométrie allongée par rapport à la première granulométrie, les pistes (5, 5A, 5C) conductrices structurées ayant une largeur plus petite que 0,2 µm.

2. Procédé suivant la revendication 1,
**caractérisé en ce que**, dans le stade a), on forme les pistes (5) conductrices dans une direction (x) primaire et/ou dans une direction (y) secondaire sensiblement perpendiculaire à la direction primaire.

3. Procédé suivant l'une des revendications 1 ou 2, **caractérisé en ce qu'**on effectue le stade b) de manière répétée.

4. Procédé suivant l'une des revendications 1 à 3, **caractérisé en ce que**, dans le stade b), on produit la zone (W) de chaleur délimitée localement par un faisceau laser aplati, par un gaz chaud, par une pluralité de lampes de chauffage et/ou par un fil de chauffage.

5. Procédé suivant l'une des revendications 1 à 4, **caractérisé en ce qu'**on forme la zone (W) de chaleur délimitée localement sous forme de bande ou sous forme de point.

6. Procédé suivant l'une des revendications 1 à 5, **caractérisé en ce que**, dans le stade a), les pistes (5) conductrices comportent un alliage de métal ou un métal dopé ayant une proportion en substance étrangère plus petite que 5%.

7. Procédé suivant l'une des revendications 1 à 6, **caractérisé en ce que** le matériau de support comporte une couche (3) formant barrière de diffusion et/ou une couche (4) de germe.

8. Procédé suivant l'une des revendications 1 à 7, **caractérisé en ce que** la zone (W) de chaleur délimitée localement a une température allant de 150 degrés Celsius à 450 degrés Celsius.

9. Procédé suivant l'une des revendications 1 à 8, **caractérisé en ce que** l'on effectue la recristallisation sous une atmosphère de gaz protecteur.
